# EUROPEAN PATENT APPLICATION

(11) **EP 4 715 085 A1**
(43) Date of publication of application: **25.03.2026**
(21) Application number: 24822716.7
(22) Date of filing: 12.06.2024
(51) Int. Cl.: C23C 16/455, C23C 16/52, C23C 16/06, H01L 29/40

(54) **PREPARATION METHOD FOR ALLOY THIN FILM**

(30) Priority: 13.06.2023 CN 202310703009
(71) Applicant: Jiangsu Leadmicro Nano-Technology Co., Ltd., Wuxi, Jiangsu 214028 (CN)
(72) Inventor: LI, Xiang, Wuxi, Jiangsu 214028 (CN); LI, Weimin, Wuxi, Jiangsu 214028 (CN); YUAN, Hongxia, Wuxi, Jiangsu 214028 (CN); MI, Ke, Wuxi, Jiangsu 214028 (CN); XU, Suochang, Wuxi, Jiangsu 214028 (CN); WANG, Xuebo, Wuxi, Jiangsu 214028 (CN); QIANG, Hui, Wuxi, Jiangsu 214028 (CN); HAN, Ping, Wuxi, Jiangsu 214028 (CN)
(74) Representative: De Arpe Tejero, Manuel
(86) International application number: PCT/CN2024/098718
(87) International publication number: WO 2024/255767

(57) **Abstract**

A preparation method for an alloy thin film, comprising: providing a reaction chamber, wherein a spraying device and a bearing platform are arranged in the reaction chamber; placing a front-end-of-line structure on the surface of the bearing platform; forming, on the surface of the front-end-of-line structure, an alloy thin film in which a first element to the M-th element have a characteristic atomic ratio, wherein the step comprises: configuring the spraying device to have a characteristic temperature, setting a characteristic distance between the spraying device and the bearing platform, configuring a flow stabilizing device to have a characteristic flow, and introducing a first precursor to the M-th precursor into the chamber under the conditions of the characteristic temperature, the characteristic distance and the characteristic flow, wherein M is an integer greater than or equal to 2; and adjusting the characteristic atomic ratio by adjusting the value of any one or more parameters, i.e., the characteristic temperature, the characteristic distance and the characteristic flow. The preparation method for an alloy thin film has a simple process, and the alloy thin film can achieve controllable adjustment of the atomic ratio between different elements.

## Description

### CROSS-REFERENCE TO RELATED APPLICATIONS

The present application claims priority to Chinese Patent Application No. 202310703009.8, entitled "A METHOD FOR MAKING ALLOY THIN FILM", filed on June 13, 2023, which is herein incorporated by reference in its entirety.

### TECHNICAL FIELD

The present disclosure relates to the technical field of semiconductor manufacturing, and in particular to a method for making an alloy thin film.

### BACKGROUND

With continuous improvement of an integration level of a semiconductor integrated circuit, a process size of a complementary metal oxide semiconductor (CMOS) device is becoming smaller, a thickness of a polycrystalline silicon gate dielectric is also decreasing, and accordingly a gate leakage current caused by direct electron tunneling increases, which easily leads to excessive power consumption in the CMOS device and even device failure. Since a high-K (high dielectric constant) dielectric is able to increase a physical thickness of the gate dielectric while maintaining a constant capacitance, replacing a traditional silicon oxynitride dielectric with the high-K dielectric has become a development trend in semiconductor technology. However, the high-K dielectric represented by a hafnium-based material has poor compatibility with the polycrystalline silicon gate, which affects electrical performance of a semiconductor device. A metal gate is able to effectively solve these problems. Therefore, process technologies of replacing the silicon nitride gate dielectric with the high-K dielectric material and using the metal gate to replace the polycrystalline silicon gate have been developed.

An effective work function is one of the most important parameters of a metal gate structure, and the effective work function is the main factor affecting a threshold voltage. The effective work function of the metal gate structure is related to a work function of a material that forms the metal gate structure. The work function of the material of the metal gate structure needs to match energy of carriers in a channel. A titanium-aluminum-based metal gate has become the preferred metal gate structure for a small-sized NMOS device, because work functions of titanium and aluminum are close to a silicon conduction band. For a high-performance device, the work function of the metal gate structure also needs to be adjustable.

At present, physical vapor deposition (PVD) or atomic layer deposition (ALD) are commonly used to prepare a titanium-aluminum thin film, so that the titanium-aluminum-based metal gate is obtained. The effective work function of the metal gate is adjusted by varying a titanium/aluminum ratio of the titanium-aluminum-based metal gate. However, in the PVD process, the gate dielectric can be damaged, and the thickness of the obtained thin film varies greatly, affecting quality of subsequent processes, thereby decreasing the electrical performance of the device. A growth temperature can be adjusted in the ALD process, making it difficult to control the titanium/aluminum ratio in the titanium-aluminum thin film, and the process for adjusting precursor pulse time is complex, which affects mass production stability. Therefore, it is necessary to provide a method for making an alloy thin film.

### SUMMARY OF THE DISCLOSURE

A technical problem to be solved by the present disclosure is how to overcome shortcomings of a method for making an alloy thin film in related art, which cannot simultaneously meet requirements of a simple process, controllable atomic ratio between different elements of the formed alloy thin film, as well good mass production stability. Therefore, the present disclosure provides a method for making an alloy thin film.

The present disclosure provides a method for making an alloy thin film. The alloy thin film includes a first element to an M-th element. The method for making the alloy thin film includes:
providing a reaction chamber, wherein the reaction chamber is provided with a spraying device and a supporting platform; in some embodiments, the spraying device is disposed on a top of the reaction chamber, and the supporting platform is disposed below the spraying device;
disposing a pre-processed structure on a surface of the supporting platform;
forming an alloy thin film with a characteristic atomic ratio of the first element to the M-th element on a surface of the pre-processed structure, including: setting the spraying device to have a characteristic temperature; setting a characteristic distance between the spraying device and the supporting platform; setting a flow-stabilizing device to have a characteristic flow rate; and introducing a first precursor to an M-th precursor into the reaction chamber through the spraying device under conditions of the characteristic temperature, the characteristic distance, and the characteristic flow rate; wherein M is an integer greater than or equal to 2; and any m-th precursor includes an m-th element, and m is an integer greater than or equal to 1 and less than or equal to M; and
adjusting the characteristic atomic ratio by adjusting any one or more selected from the group consisting of the characteristic temperature, the characteristic distance, and the characteristic flow rate.

In some embodiments, any m1-th element and any m2-th element of the first element to the M-th element have different atomic activity, in some embodiments, atomic activity of the m1-th element is higher than that of the m2-th element, each of m1 and m2 is the integer greater than or equal to 1 and less than or equal to M, and m1 is not equal to m2. The characteristic atomic ratio of the m1-th element to the m2-th element increases as the characteristic temperature increases, the characteristic atomic ratio of the m1-th element to the m2-th element decreases as the characteristic distance increases, and the characteristic atomic ratio of the m1-th element to the m2-th element decreases as the characteristic flow rate increases.

In some embodiments, M is equal to 2, and the alloy thin film includes a titanium element and an aluminum element. The introducing the first precursor to the M-th precursor into the reaction chamber through the spraying device under conditions of the characteristic temperature, the characteristic distance, and the characteristic flow rate, includes:
introducing a titanium-containing precursor and an aluminum-containing precursor into the reaction chamber through the spraying device under the conditions of the characteristic temperature, the characteristic distance, and the characteristic flow rate;
adjusting a characteristic atomic ratio of the titanium element to the aluminum element of the alloy thin film by adjusting the characteristic temperature; and/or
adjusting the characteristic atomic ratio of the titanium element to the aluminum element of the alloy thin film by adjusting the characteristic distance; and/or
adjusting the characteristic atomic ratio of the titanium element to the aluminum element of the alloy thin film by adjusting the characteristic flow rate.

In some embodiments, the adjusting a characteristic atomic ratio of the titanium element to the aluminum element of the alloy thin film by adjusting the characteristic temperature, includes: increasing the characteristic atomic ratio of the titanium element to the aluminum element of the alloy thin film by increasing the characteristic temperature; or decreasing the characteristic atomic ratio of the titanium element to the aluminum element of the alloy thin film by decreasing the characteristic temperature.

In some embodiments, the adjusting the characteristic atomic ratio of the titanium element to the aluminum element of the alloy thin film by adjusting the characteristic distance, includes: decreasing the characteristic atomic ratio of the titanium element to the aluminum element of the alloy thin film by increasing the characteristic distance; or increasing the characteristic atomic ratio of the titanium element to the aluminum element of the alloy thin film by decreasing the characteristic distance.

In some embodiments, the adjusting the characteristic atomic ratio of the titanium element to the aluminum element of the alloy thin film by adjusting the characteristic flow rate, includes: decreasing the characteristic atomic ratio of the titanium element to the aluminum element of the alloy thin film by increasing the characteristic flow rate; or increasing the characteristic atomic ratio of the titanium element to the aluminum element of the alloy thin film by decreasing the characteristic flow rate.

In some embodiments, during forming different alloy thin films with different characteristic atomic ratios, a flow rate of any m-th precursor remains unchanged, a temperature of the reaction chamber remains unchanged, pulse time of any m-th precursor remains unchanged, and a flow rate of carrier gas remains unchanged in a case where the m-th precursor is introduced into the reaction chamber.

In some embodiments, a process for forming the alloy thin film with the characteristic atomic ratio of the first element to the M-th element on the surface of the pre-processed structure, includes: an atomic layer deposition process. The introducing the first precursor to the M-th precursor into the reaction chamber through the spraying device under conditions of the characteristic temperature, the characteristic distance, and the characteristic flow rate, includes: performing a plurality of consecutive sub-cycle depositions. Any one of the plurality of sub-cycle depositions is configured to allow a single atomic layer film to be deposited. In any one of the plurality of sub-cycle depositions, the first precursor to the M-th precursor are alternately introduced into the reaction chamber through the spraying device under the conditions of the characteristic temperature, the characteristic distance, and the characteristic flow rate; and a purging operation is further performed between introducing different precursors.

In some embodiments, the characteristic temperature ranges from 120 °C to 220 °C, the characteristic distance ranges from 2 mm to 15 mm, and the characteristic flow rate ranges from 500 sccm to 1100 sccm.

In some embodiments, a temperature of the titanium-containing precursor before being introduced into the spraying device is a room temperature (in some embodiments, the temperature of the titanium-containing precursor before being introduced into the spraying device ranges from 18 °C to 35 °C), and a temperature of the aluminum-containing precursor before being introduced into the spraying device ranges from 40 °C to 115 °C.

In some embodiments, the reaction chamber includes a first reaction sub-chamber and a second reaction sub-chamber disposed in the first reaction sub-chamber, a heating device is disposed between the first reaction sub-chamber and the second reaction sub-chamber, and the supporting platform is disposed in the second reaction sub-chamber.

In some embodiments, the alloy thin film is a metal gate layer. The pre-processed structure includes a substrate layer, a high dielectric gate dielectric layer disposed on a surface of the substrate layer, and a barrier layer disposed on a surface of the high dielectric gate dielectric layer away from the substrate layer. The metal gate layer is disposed on a surface of the barrier layer away from the substrate layer.

The effects of the present disclosure are as follows. The method for making the alloy thin film in the present disclosure includes: providing a reaction chamber, wherein the reaction chamber is provided with the spraying device and the supporting platform; disposing the pre-processed structure on the surface of the supporting platform; and forming the alloy thin film with the characteristic atomic ratio of the first element to the M-th element on the surface of the pre-processed structure. The forming the alloy thin film with the characteristic atomic ratio of the first element to the M-th element on the surface of the pre-processed structure includes: setting the spraying device to have a characteristic temperature; setting a characteristic distance between the spraying device and the supporting platform; setting a flow-stabilizing device to have a characteristic flow rate; and introducing the first precursor to the M-th precursor into the reaction chamber under the conditions of the characteristic temperature, the characteristic distance, and the characteristic flow rate. M is the integer greater than or equal to 2. The method for making the alloy thin film further includes adjusting the characteristic atomic ratio by adjusting any one or more selected from the group consisting of the characteristic temperature, the characteristic distance, and the characteristic flow rate. This can avoid the thermal instability caused by adjusting the growth temperature (i.e., the temperature of the reaction chamber) of the thin film deposition, and can decrease the correlation effects with the carrier gas carrying the source during the precursor pulse adjustment. The process is simple, and the atomic ratio of different elements of the alloy thin film can be accurately controlled. The mass production stability is good, thereby achieving stable adjustment of the effective work function of the metal gate layer that is the alloy thin film and ensuring the electrical performance of the device.

Moreover, the process for forming the alloy thin film with the characteristic atomic ratio of the first element to the M-th element on the surface of the pre-processed structure, includes the atomic layer deposition process. The atomic layer deposition process provides excellent conformal step coverage, which can improve uniformity of the alloy thin film and ensure the processing quality of subsequent processes, thereby improving the electrical performance of the device.

Furthermore, the reaction chamber includes the first reaction sub-chamber and the second reaction sub-chamber disposed in the first reaction sub-chamber. The heating device is disposed between the first reaction sub-chamber and the second reaction sub-chamber, and the supporting platform is disposed in the second reaction sub-chamber. The heating device is disposed between the first reaction sub-chamber and the second reaction sub-chamber, which can evenly distribute the temperature in the first reaction sub-chamber and the second reaction sub-chamber, while preventing significant temperature fluctuations in the reaction chamber, further decreasing the impact of thermal instability, and improving the quality and preparation effect of the alloy thin film.

In addition, the alloy thin film is the metal gate layer. The pre-processed structure includes the substrate layer, the high dielectric gate dielectric layer disposed on the surface of the substrate layer, and the barrier layer disposed on the surface of the high dielectric gate dielectric layer away from the substrate layer. The metal gate layer is disposed on the surface of the barrier layer away from the substrate layer. By adjusting the characteristic atomic ratio through adjusting any one or more selected from the group consisting of the characteristic temperature, the characteristic distance, and the characteristic flow rate, the thermal instability caused by adjusting the growth temperature (i.e., the temperature of the reaction chamber) of the thin film deposition can be avoided. This prevents mutual diffusion or chemical reactions between a metal material of the metal gate layer and a material of the high dielectric gate dielectric layer during varying the growth temperature, which would otherwise vary the atomic ratio of the elements of the metal gate layer and be difficult to accurately control the atomic ratio. This can also decrease the correlation effects with the carrier gas carrying the source during the precursor pulse adjustment, facilitating process adjustment. The barrier layer is disposed between the high dielectric gate dielectric layer and the metal gate layer, which can further prevent mutual diffusion or chemical reactions between the metal material of the metal gate layer and the material of the high dielectric gate dielectric layer, thereby ensuring the electrical performance of the device.

### BRIEF DESCRIPTION OF THE DRAWINGS

In order to more clearly illustrate the technical solutions in some embodiments of the present disclosure or in the related art, hereinafter, the accompanying drawings that are used in the description of some embodiments or the related art will be briefly described. Obviously, the accompanying drawings in the description below are merely the accompanying drawings in some embodiments of the present disclosure. For those of ordinary skill in the art, other accompanying drawings may be obtained based on these accompanying drawings without any creative efforts.

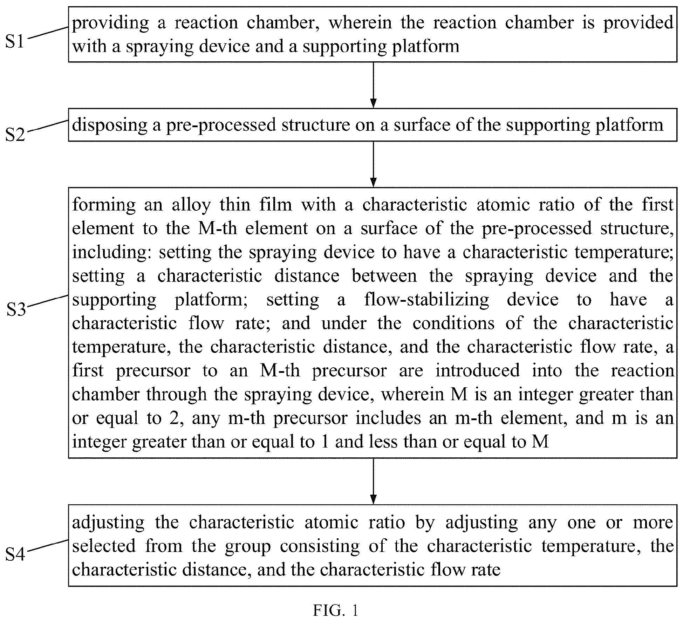

FIG. 1 is a flowchart of a method for making an alloy thin film provided in an embodiment of the present disclosure.

### DETAILED DESCRIPTION

The technical solutions in some embodiments of the present disclosure may be clearly and completely described in conjunction with accompanying drawings. Obviously, the described embodiments are only a part of the embodiments of the present disclosure, and not all embodiments. Based on the embodiments in the present disclosure, all other embodiments obtained by those of ordinary skill in the art without creative effort are within the scope of the present disclosure.

In the description of the present disclosure, the orientations or positional relationships indicated by the terms, "center", "up", "down", "left", "right", "vertical", "horizontal", "inside", "outside", etc. are based on the orientations or positional relationships shown in the accompanying drawings. It is only intended to facilitate the description of the embodiments of the present disclosure and simplify the description, but does not indicate or imply that the device or the element referred to must have a specific orientation, be constructed and operated in a specific orientation. Therefore, it cannot be understood as a limitation on the embodiments of the present disclosure. The terms "first", "second", and "third" in the present disclosure are only configured to describe purposes and cannot be understood as indicating or implying relative importance.

In the description of the present disclosure, it should be noted that unless otherwise expressly specified and limited, the terms "installation", "connecting", and "connection" should be broadly understood. For example, it may be a fixed connection, a detachable connection, or an integrated connection; it may be a mechanical connection or an electrical connection; it may be a direct connection or an indirect connection through an intermediate medium; it may be internal communication of two elements. For those of ordinary skill in the art, the specific meanings of the above terms may be understood according to specific situation.

In addition, the technical features in different embodiments of the present disclosure described below can be combined with each other as long as they do not conflict.

In an embodiment, a method for making an alloy thin film is provided. The alloy thin film includes a first element to an M-th element. As illustrated in FIG. 1, the method for making the alloy thin film includes the following operations.

At block S1, the method for making the alloy thin film may include providing a reaction chamber, wherein the reaction chamber is provided with a spraying device and a supporting platform. In some embodiments, the spraying device is disposed on a top of the reaction chamber, and the supporting platform is disposed below the spraying device.

At block S2, the method for making the alloy thin film may include disposing a pre-processed structure on a surface of the supporting platform.

At block S3, the method for making the alloy thin film may include forming an alloy thin film with a characteristic atomic ratio of the first element to the M-th element on a surface of the pre-processed structure. The operation at block S3 may include: setting the spraying device to have a characteristic temperature, setting a characteristic distance between the spraying device and the supporting platform, and setting a flow-stabilizing device to have a characteristic flow rate. In some embodiments, the spraying device is a spraying plate, and the flow-stabilizing device is a mass flow controller for purge gas. Under the conditions of the characteristic temperature, the characteristic distance, and the characteristic flow rate, a first precursor to an M-th precursor are introduced into the reaction chamber through the spraying device. M is an integer greater than or equal to 2. Any m-th precursor includes an m-th element, and m is an integer greater than or equal to 1 and less than or equal to M.

At block S4, the method for making the alloy thin film may include adjusting the characteristic atomic ratio by adjusting any one or more selected from the group consisting of the characteristic temperature, the characteristic distance, and the characteristic flow rate.

Adjusting a thin film deposition growth temperature (i.e., a temperature of the reaction chamber) can cause the alloy thin film to have thermal instability, and the elements of the alloy thin film diffuse to a gate dielectric layer. This not only affects the device performance, but also causes the atomic ratio of different elements to vary uncontrollably. Moreover, the precursor generally enters the reaction chamber through carrier gas that carries a source, which requires corresponding adjustment of the carrier gas flow rate during precursor pulse adjustment. This not only makes the process complex, but also makes it difficult to control the atomic ratio of different elements of the alloy thin film, resulting in poor batch stability, and thus affecting the effective work function adjustment of a metal gate layer and the electrical performance of the device.

In the method of making the alloy thin film provided in the present embodiment, adsorption capacity of different element atoms can be affected by varying the temperature of the spraying device and the distance between the spraying device and the supporting platform. Desorption capability of different element atoms can be affected by varying the flow rate of the flow-stabilizing device for the purge gas. The thermal instability effect caused by the growth temperature adjustment on the alloy thin film elements and correlation effects of the carrier gas flow rate caused by the precursor pulse adjustment can be avoided. Through experimental verification, the titanium/aluminum ratio (i.e., the atomic ratio of a titanium element to an aluminum element) in the titanium-aluminum-based alloy thin film, varies positively and linearly with the temperature of the spraying device, and varies negatively and linearly with the distance between the spraying device and the supporting platform and with the flow-stabilizing flow rate of the purge gas, respectively. That is, the titanium/aluminum ratio increases as the temperature of the spraying device increases, decreases as the distance between the spraying device and the supporting platform increases, and decreases as the flow-stabilizing flow rate of the purge gas increases. In a case where the temperature of the reaction chamber or the pulse time is adjusted, the titanium/aluminum ratio shows a curved variation. Therefore, by adjusting any one or more selected from the group consisting of the characteristic temperature, the characteristic distance, and the characteristic flow rate, the characteristic atomic ratio of the alloy thin film can be adjusted to a target ratio. Therefore, the method for making the alloy thin film can easily achieve accurate and controllable atomic ratio of various elements of the alloy thin film, and effectively improve the mass production stability.

In some embodiments, any m1-th element and any m2-th element of the first element to the M-th element have different atomic activity. In some embodiments, the atomic activity of the m1-th element is higher than that of the m2-th element. m1 is the integer greater than or equal to 1 and less than or equal to M, m2 is the integer greater than or equal to 1 and less than or equal to M, and m1 is not equal to m2. The characteristic atomic ratio of the m1-th element to the m2-th element increases as the characteristic temperature increases. The characteristic atomic ratio of the m1-th element to the m2-th element decreases as the characteristic distance increases, and the characteristic atomic ratio of the m1-th element to the m2-th element decreases as the characteristic flow rate increases.

In some embodiments, M is equal to 2. The alloy thin film includes the titanium element and the aluminum element. A process for introducing the first precursor to the M-th precursor into the reaction chamber through the spraying device under the conditions of the characteristic temperature, the characteristic distance, and the characteristic flow rate, includes: introducing a titanium-containing precursor and an aluminum-containing precursor into the reaction chamber through the spraying device under the conditions of the characteristic temperature, the characteristic distance, and the characteristic flow rate. The method further includes: adjusting the characteristic atomic ratio of the titanium element to the aluminum element of the alloy thin film by adjusting the characteristic temperature; and/or adjusting the characteristic atomic ratio of the titanium element to the aluminum element of the alloy thin film by adjusting the characteristic distance; and/or adjusting the characteristic atomic ratio of the titanium element to the aluminum element of the alloy thin film by adjusting the characteristic flow rate.

In some embodiments, the operation of adjusting the characteristic atomic ratio of the titanium element to the aluminum element of the alloy thin film by adjusting the characteristic temperature, includes: increasing the characteristic atomic ratio of the titanium element to the aluminum element of the alloy thin film by increasing the characteristic temperature, or decreasing the characteristic atomic ratio of the titanium element to the aluminum element of the alloy thin film by decreasing the characteristic temperature.

In some embodiments, the operation of adjusting the characteristic atomic ratio of the titanium element to the aluminum element of the alloy thin film by adjusting the characteristic distance, includes: decreasing the characteristic atomic ratio of the titanium element to the aluminum element of the alloy thin film by increasing the characteristic distance, or increasing the characteristic atomic ratio of the titanium element to the aluminum element of the alloy thin film by decreasing the characteristic distance.

In some embodiments, the adjusting the characteristic atomic ratio of the titanium element to the aluminum element of the alloy thin film by adjusting the characteristic flow rate, includes: decreasing the characteristic atomic ratio of the titanium element to the aluminum element of the alloy thin film by increasing the characteristic flow rate, or increasing the characteristic atomic ratio of the titanium element to the aluminum element of the alloy thin film by decreasing the characteristic flow rate.

In some embodiments, in a case where different alloy thin films with different characteristic atomic ratios are formed, the flow rate of any m-th precursor remains unchanged, the temperature of the reaction chamber remains unchanged, the pulse time of any m-th precursor remains unchanged, and a flow rate of the carrier gas remains unchanged when the m-th precursor is introduced into the reaction chamber.

M is equal to 2. In a case where the titanium-containing precursor and the aluminum-containing precursor are alternately introduced into the reaction chamber through the spraying device under the conditions of the characteristic temperature, the characteristic distance, and the characteristic flow rate to form different alloy thin films with different characteristic atomic ratios, the flow rate of the titanium-containing precursor and the flow rate of the aluminum-containing precursor remains unchanged, the temperature of the reaction chamber remains unchanged, the pulse time of the titanium-containing precursor and the pulse time of the aluminum-containing precursor remains unchanged, and the flow rate of the carrier gas remains unchanged during the carrier gas carrying the titanium-containing precursor and the aluminum-containing precursor into the reaction chamber. In some embodiments, the temperature of the reaction chamber ranges from 350 °C to 450 °C. In some embodiments, the temperature of the reaction chamber is 380 °C, 400 °C, or 420 °C. The first precursor and the second precursor are introduced into the reaction chamber through the carrier gas carrying the source, such as carrying the titanium-containing precursor or the aluminum-containing precursor into the reaction chamber through the carrier gas. The carrier gas includes inert gas, such as nitrogen. The flow rate of the carrier gas may be 1000 sccm and a purity of the carrier gas may be 99.9999%. The pulse time of the titanium-containing precursor ranges from 0.1 seconds to 5 seconds. In some embodiments, the pulse time of the titanium-containing precursor is 3 seconds. The pulse time of the aluminum-containing precursor ranges from 0.1 seconds to 35 seconds. In some embodiments, the pulse time of the aluminum-containing precursor is 20 seconds.

In some embodiments, the process of forming the alloy thin film with the characteristic atomic ratio of the first element to the M-th element on the surface of the pre-processed structure, includes: an atomic layer deposition process. The atomic layer deposition process provides excellent conformal step coverage, which can improve uniformity of the deposited alloy thin film and ensure the processing quality of subsequent processes, further improving the electrical performance of the device.

In some embodiments, the operation of introducing the first precursor to the M-th precursor into the reaction chamber through the spraying device under the conditions of the characteristic temperature, the characteristic distance, and the characteristic flow rate, includes: performing multiple consecutive sub-cycle depositions, any one of the multiple sub-cycle depositions is configured to allow a single atomic layer film to be deposited. In any one of the multiple sub-cycle depositions, the first precursor to the M-th precursor are alternately introduced into the reaction chamber through the spraying device under the conditions of the characteristic temperature, the characteristic distance, and the characteristic flow rate. A purging operation is further performed between the operations of introducing different precursors.

In some embodiments, the characteristic temperature ranges from 120 °C to 220 °C. In some embodiments, the characteristic temperature may be 130 °C, 150 °C, 180 °C, 200 °C, or 210 °C.

In some embodiments, the characteristic distance ranges from 2 mm to 15 mm. In some embodiments, the characteristic distance may be 3 mm, 4 mm, 6 mm, 8 mm, 10 mm, 12 mm, or 14 mm.

In some embodiments, the characteristic flow rate ranges from 500 sccm to 1100 sccm. In some embodiments, the characteristic flow rate may be 550 sccm, 600 sccm, 650 sccm, 700 sccm, 850 sccm, 950 sccm, or 1000 sccm.

In some embodiments, before introducing the titanium-containing precursor and the aluminum-containing precursor into the reaction chamber under the conditions of the characteristic temperature, the characteristic distance, and the characteristic flow rate, a temperature of the titanium-containing precursor is a room temperature. In some embodiments, the temperature of the titanium-containing precursor ranges from 18 °C to 35 °C. In some embodiments, the temperature of the titanium-containing precursor is 20 °C, 25 °C, or 30 °C. The temperature of the aluminum-containing precursor ranges from 40 °C to 115 °C. In some embodiments, the temperature of the aluminum-containing precursor is 50 °C, 65 °C, 75 °C, 85 °C, or 100 °C.

In some embodiments, the reaction chamber includes a first reaction sub-chamber and a second reaction sub-chamber that is disposed in the first reaction sub-chamber. A heating device is disposed between the first reaction sub-chamber and the second reaction sub-chamber, and the supporting platform is disposed in the second reaction sub-chamber. The heating device is disposed between the first reaction sub-chamber and the second reaction sub-chamber, which can evenly distribute the temperature in the first reaction sub-chamber and the second reaction sub-chamber, thus improving the quality and preparation effect of the alloy thin film.

In some embodiments, the alloy thin film is the metal gate layer. The pre-processed structure includes a substrate layer, a high dielectric gate dielectric layer disposed on a surface of the substrate layer, and a barrier layer disposed on a surface of the high dielectric gate dielectric layer away from the substrate layer. The metal gate layer is disposed on a surface of the barrier layer away from the substrate layer. By adjusting the characteristic atomic ratio through adjusting any one or more selected from the group consisting of the characteristic temperature, the characteristic distance, and the characteristic flow rate, the thermal instability caused by adjusting the growth temperature (i.e., the temperature of the reaction chamber) of the thin film deposition can be avoided. This prevents mutual diffusion or chemical reactions between a metal material of the metal gate layer and a material of the high dielectric gate dielectric layer during varying the growth temperature, which would otherwise vary the atomic ratio of the elements of the metal gate layer and be difficult to accurately control the atomic ratio. This can also decrease the correlation effects with the carrier gas carrying the source during the precursor pulse adjustment, facilitating process adjustment. The barrier layer is disposed between the high dielectric gate dielectric layer and the metal gate layer, which can further prevent mutual diffusion or chemical reactions between the metal material of the metal gate layer and the material of the high dielectric gate dielectric layer, thereby ensuring the electrical performance of the device.

In some embodiments, the substrate layer includes a silicon substrate layer, a material of the high dielectric gate dielectric layer includes hafnium oxide, and a material of the barrier layer includes titanium nitride.

In the method for making the alloy thin film provided in the present embodiment, adjusting the characteristic atomic ratio of the alloy thin film to the target ratio can be simply achieved, thereby achieving controllable adjustment of the effective work function of the metal gate layer. This can avoid the thermal instability of the elements of the alloy thin film caused by adjusting the temperature of the reaction chamber (i.e., the growth temperature of the thin film), which would otherwise lead to uncontrollable characteristic atomic ratio of the alloy thin film. This can improve the mass production stability of the characteristic atomic ratio of the alloy thin film, prevents mutual diffusion or chemical reactions between the metal material of the alloy thin film and the material of the high dielectric gate medium in the complementary metal oxide semiconductor device, avoids larger leakage current and effective work function shift caused by the complementary metal oxide semiconductor device, and improves the electrical performance and product yield of the complementary metal oxide semiconductor device.

In the method for making the alloy thin film provided in the present embodiment, adjusting the pulse time of the first precursor to the M-th precursor can be avoided. Due to the correlation effects of the pulse time of the first precursor to the M-th precursor, the adjustment is more complex. Therefore, the method for making the alloy thin film provided in the present embodiment makes the preparation of the alloy thin film simpler.

The method for making the alloy thin film using the atomic layer deposition process can avoid damage to a high-K (high dielectric constant) gate dielectric layer of the complementary metal oxide semiconductor device, and can also avoid significant thickness variations of the alloy thin film, especially for a fin field-effect transistor (FinFET device) with a high aspect ratio. This can prevent leakage current of the fin field-effect transistor and impact on the quality of subsequent processes, further improving the electrical performance and the product yield of the fin field-effect transistor or the complementary metal oxide semiconductor device.

The alloy thin films with different characteristic atomic ratios, i.e. the metal gate layers with different characteristic atomic ratios, can enable the metal gate structure to have different effective work functions close to a conduction band edge of the silicon substrate. Therefore, process compatibility among the alloy thin film, a high-K (high dielectric constant) dielectric material layer of a corresponding N-type metal oxide semiconductor, and the silicon substrate can be improved, and the electrical performance of the N-type metal oxide semiconductor can be improved.

The technical solutions of the present disclosure can be clearly and completely described through the following embodiments.

### Example 1

The example 1 provides the method for making the alloy thin film. The method includes: providing the reaction chamber, the top of the reaction chamber provided with the spraying device, and the reaction chamber further having the supporting platform disposed below the spraying device; disposing the pre-processed structure on the surface of the supporting platform; and forming the alloy thin film with the characteristic atomic ratio of the first element to the second element on the surface of the pre-processed structure. In some embodiments, the operation includes: setting the characteristic temperature of the spraying device to 120 °C, setting the characteristic distance between the spraying device and the bearing platform to 8 mm, and setting the characteristic flow rate of the flow-stabilizing device to 1000 sccm.

In some embodiments, the method further includes: setting the temperature of the reaction chamber to constant 420 °C, setting pressure inside the reaction chamber to 4 torr, setting the pulse time of the first precursor to 4 seconds, and setting the pulse time of the second precursor to 15 seconds. Before introducing the first precursor and the second precursor into the reaction chamber under the conditions of the characteristic temperature, the characteristic distance, and the characteristic flow rate, the temperature of the first precursor is 20 °C and the temperature of the second precursor is 80 °C.

In some embodiments, the operation of introducing the first precursor to the second precursor into the reaction chamber under the conditions of the characteristic temperature, the characteristic distance, and the characteristic flow rate, includes: performing multiple consecutive sub-cycle depositions, any one of the multiple sub-cycle depositions is configured to allow a single atomic layer film to be deposited. In any one of the multiple sub-cycle depositions, the first precursor and the second precursor are alternately introduced into the reaction chamber under the conditions of the characteristic temperature, the characteristic distance, and the characteristic flow rate. The purging operation using the purge gas is further performed between the operations of introducing different precursors. In some embodiments, time for purging the first precursor is 10 seconds, and time for purging the second precursor is 20 seconds. During the purging process for the first precursor and the second precursor, a volume flow rate of the purge gas may be 1000 sccm, and the purge gas includes the inert gas, such as the nitrogen.

The first precursor and the second precursor are introduced into the reaction chamber through the carrier gas that carries the first precursor and the second precursor, and the carrier gas includes the inert gas such as the nitrogen. The flow rate of the carrier gas may be 1000 sccm, and the purity of the carrier gas may be 99.9999%. The first precursor is the titanium-containing precursor and the second precursor is the aluminum-containing precursor. In some embodiments, a material of the first precursor is titanium chloride and a material of the second precursor is triethylaluminum. The atomic activity of an aluminum atom is higher than that of a titanium atom, and a ratio of the titanium element to the aluminum element of the formed alloy thin film may be 0.3. The effective work function of the metal gate structure formed by the alloy thin film may be 4.46 eV.

The characteristic atomic ratio of the first element to the second element of the alloy thin film can be adjusted by adjusting the characteristic temperature. In some embodiments, the characteristic atomic ratio of the first element to the second atom ranges from 0.6 to 1, and the characteristic temperature ranges from 120 °C to 220 °C. The effect of the characteristic temperature on the adsorption capacity of different element atoms is different. In some embodiments, after increasing the characteristic temperature, the atomic activity of the aluminum atom is greater than that of the titanium atom. Therefore, increasing the characteristic temperature allows the aluminum atom to be more easily adsorbed, and the content of the aluminum atom is greater than that of the titanium atom in the formed alloy thin film. Therefore, the characteristic atomic ratio of the titanium element to the aluminum element can increase as the characteristic temperature increases.

### Example 2

The example 2 provides a method for making the alloy thin film, which differs from the method for making the alloy thin film provided in the example 1 in that: in the example 2, the characteristic distance between the spraying device and the supporting platform is set to 6 mm, the ratio of the titanium element to the aluminum element of the formed alloy thin film is 1.2, and the effective work function of the metal gate structure formed by the alloy thin film is 4.51 eV.

The characteristic atomic ratio of the first element to the second element of the alloy thin film can be adjusted by adjusting the characteristic distance between the spraying device and the supporting platform. In some embodiments, the characteristic atomic ratio of the first element to the second element ranges from 0.2 to 0.6, and the characteristic distance between the spraying device and the supporting platform ranges from 2 mm to 15 mm. In the present embodiment, since an atomic radius (1.45 angstroms) of the titanium atom is greater than an atomic radius (1.43 angstroms) of the aluminum atom, magnitude of the characteristic distance has different effects on the adsorption capacity of the aluminum atom and the titanium atom. Therefore, the characteristic atomic ratio of the titanium element to the aluminum element decreases as the characteristic distance between the spraying device and the supporting platform increases.

### Example 3

The example 3 provides a method for making the alloy thin film, which differs from the method for making the alloy thin film provided in the example 1 in that: in the example 3, the characteristic flow rate of the flow-stabilizing device is 800 sccm, the ratio of the titanium element to the aluminum element of the formed alloy thin film is 0.6, and the effective work function of the metal gate structure formed by the alloy thin film is 4.48 eV.

The characteristic atomic ratio of the first element to the second element of the alloy thin film can be adjusted by adjusting the characteristic flow rate of equilibrium gas introduced into the reaction chamber. In some embodiments, the characteristic atomic ratio of the first element to the second element ranges from 0.7 to 0.9, and the characteristic flow rate of the flow-stabilizing device ranges from 500 sccm to 1100 sccm, which is usually similar to the volume flow rate of the purge gas. In the present embodiment, the characteristic flow rate of the flow-stabilizing device can affect the desorption capability of the titanium atom and the desorption capability of the aluminum atom. Therefore, the characteristic atomic ratio of the titanium element to the aluminum element decreases as the characteristic flow rate increases.

Obviously, the above embodiments are only examples provided for clear illustration, and not limitations on the implementation methods. For those of ordinary skill in the art, other changes or modifications in different forms can be made based on the above explanation. It is not necessary and impossible to exhaustively list all implementation methods here. The obvious changes or variations arising from this are still within the protection scope of the present disclosure.

## Claims

1. A method for making an alloy thin film comprising a first element to an M-th element, **characterized by** comprising:
providing a reaction chamber, wherein the reaction chamber is provided with a spraying device and a supporting platform;
disposing a pre-processed structure on a surface of the supporting platform;
forming an alloy thin film with a characteristic atomic ratio of the first element to the M-th element on a surface of the pre-processed structure, comprising:
setting the spraying device to have a characteristic temperature;
setting a characteristic distance between the spraying device and the supporting platform;
setting a flow-stabilizing device to have a characteristic flow rate; and
introducing a first precursor to an M-th precursor into the reaction chamber through the spraying device under conditions of the characteristic temperature, the characteristic distance, and the characteristic flow rate; wherein M is an integer greater than or equal to 2; and any m-th precursor comprises an m-th element, and m is an integer greater than or equal to 1 and less than or equal to M; and
adjusting the characteristic atomic ratio by adjusting any one or more selected from the group consisting of the characteristic temperature, the characteristic distance, and the characteristic flow rate.

2. The method for making the alloy thin film according to claim 1, wherein any m1-th element and any m2-th element of the first element to the M-th element have different atomic activity, each of m1 and m2 is the integer greater than or equal to 1 and less than or equal to M, and m1 is not equal to m2; and
the characteristic atomic ratio of the m1-th element to the m2-th element increases as the characteristic temperature increases, the characteristic atomic ratio of the m1-th element to the m2-th element decreases as the characteristic distance increases, and the characteristic atomic ratio of the m1-th element to the m2-th element decreases as the characteristic flow rate increases.

3. The method for making the alloy thin film according to claim 1, wherein M is equal to 2, and the alloy thin film comprises a titanium element and an aluminum element;
the introducing the first precursor to the M-th precursor into the reaction chamber through the spraying device under conditions of the characteristic temperature, the characteristic distance, and the characteristic flow rate, comprises:
introducing a titanium-containing precursor and an aluminum-containing precursor into the reaction chamber through the spraying device under the conditions of the characteristic temperature, the characteristic distance, and the characteristic flow rate;
adjusting the characteristic atomic ratio of the titanium element to the aluminum element of the alloy thin film by adjusting the characteristic temperature; and/or
adjusting the characteristic atomic ratio of the titanium element to the aluminum element of the alloy thin film by adjusting the characteristic distance; and/or
adjusting the characteristic atomic ratio of the titanium element to the aluminum element of the alloy thin film by adjusting the characteristic flow rate.

4. The method for making the alloy thin film according to claim 3, wherein the adjusting the characteristic atomic ratio of the titanium element to the aluminum element of the alloy thin film by adjusting the characteristic temperature, comprises:
increasing the characteristic atomic ratio of the titanium element to the aluminum element of the alloy thin film by increasing the characteristic temperature; or
decreasing the characteristic atomic ratio of the titanium element to the aluminum element of the alloy thin film by decreasing the characteristic temperature.

5. The method for making the alloy thin film according to claim 3, wherein the adjusting the characteristic atomic ratio of the titanium element to the aluminum element of the alloy thin film by adjusting the characteristic distance, comprises:
decreasing the characteristic atomic ratio of the titanium element to the aluminum element of the alloy thin film by increasing the characteristic distance; or
increasing the characteristic atomic ratio of the titanium element to the aluminum element of the alloy thin film by decreasing the characteristic distance.

6. The method for making the alloy thin film according to claim 3, wherein the adjusting the characteristic atomic ratio of the titanium element to the aluminum element of the alloy thin film by adjusting the characteristic flow rate, comprises:
decreasing the characteristic atomic ratio of the titanium element to the aluminum element of the alloy thin film by increasing the characteristic flow rate; or
increasing the characteristic atomic ratio of the titanium element to the aluminum element of the alloy thin film by decreasing the characteristic flow rate.

7. The method for making the alloy thin film according to claim 1, wherein during forming different alloy thin films with different characteristic atomic ratios, a flow rate of any m-th precursor remains unchanged, a temperature of the reaction chamber remains unchanged, pulse time of any m-th precursor remains unchanged, and a flow rate of carrier gas remains unchanged in a case where the m-th precursor is introduced into the reaction chamber.

8. The method for making the alloy thin film according to claim 1, wherein a process for forming the alloy thin film with the characteristic atomic ratio of the first element to the M-th element on the surface of the pre-processed structure, comprises: an atomic layer deposition process;
the introducing the first precursor to the M-th precursor into the reaction chamber through the spraying device under conditions of the characteristic temperature, the characteristic distance, and the characteristic flow rate, comprises:
performing a plurality of consecutive sub-cycle depositions;
wherein any one of the plurality of sub-cycle depositions is configured to allow a single atomic layer film to be deposited; in any one of the plurality of sub-cycle depositions, the first precursor to the M-th precursor are alternately introduced into the reaction chamber through the spraying device under the conditions of the characteristic temperature, the characteristic distance, and the characteristic flow rate; and a purging operation is further performed between introducing different precursors.

9. The method for making the alloy thin film according to claim 1, wherein the characteristic temperature ranges from 120 °C to 220 °C;
the characteristic distance ranges from 2 mm to 15 mm; and
the characteristic flow rate ranges from 500 sccm to 1100 sccm.

10. The method for making the alloy thin film according to claim 3, wherein a temperature of the titanium-containing precursor before being introduced into the spraying device is a room temperature, and a temperature of the aluminum-containing precursor before being introduced into the spraying device ranges from 40 °C to 115 °C.

11. The method for making the alloy thin film according to claim 1, wherein the reaction chamber comprises a first reaction sub-chamber and a second reaction sub-chamber disposed in the first reaction sub-chamber, a heating device is disposed between the first reaction sub-chamber and the second reaction sub-chamber, and the supporting platform is disposed in the second reaction sub-chamber.

12. The method for making the alloy thin film according to claim 1, wherein the alloy thin film is a metal gate layer;
the pre-processed structure comprises a substrate layer, a high dielectric gate dielectric layer disposed on a surface of the substrate layer, and a barrier layer disposed on a surface of the high dielectric gate dielectric layer away from the substrate layer; and
the metal gate layer is disposed on a surface of the barrier layer away from the substrate layer.
